# EUROPEAN PATENT SPECIFICATION

(11) **EP 4 356 403 B1**
(45) Date of publication and mention of the grant of the patent: **31.12.2025**
(21) Application number: 22938736.0
(22) Date of filing: 19.05.2022
(51) Int. Cl.: H01B 12/06

(54) **NON-PLANAR HTS COILS AND MANUFACTURING TECHNIQUES**
NICHTPLANARE HTS-SPULEN UND HERSTELLUNGSVERFAHREN
BOBINES HTS NON PLANES ET TECHNIQUES DE FABRICATION

(30) Priority: 20.05.2021 US 202163191066 P; 16.02.2022 US 202263310709 P
(43) Date of publication of application: 24.04.2024
(73) Proprietor: Massachusetts Institute Of Technology, Cambridge, MA 02139 (US); Commonwealth Fusion Systems LLC, Cambridge, MA 02139 (US)
(72) Inventor: GRANETZ, Robert, S., Newton, Massachusetts 02460-1919 (US); VIEIRA, Rui, Billerica, Massachusetts 01821 (US); WHYTE, Dennis, G., Brookline, Massachusetts 02446 (US); MUMGAARD, Robert, Boston, Massachusetts 02215 (US)
(74) Representative: Murgitroyd & Company
(86) International application number: PCT/US2022/030047
(87) International publication number: WO 2023/234913

(56) References cited:
- US-A1- 2014 243 207
- ZACHARY S HARTWIG ET AL: "VIPER: an industrially scalable high-current high-temperature superconductor cable", SUPERCONDUCTOR SCIENCE AND TECHNOLOGY, IOP PUBLISHING, TECHNO HOUSE, BRISTOL, GB, vol. 33, no. 11, 7 October 2020 (2020-10-07), XP020358283, ISSN: 0953-2048, [retrieved on 20201007], DOI: 10.1088/1361-6668/ABB8C0
- MCINTYRE PETER M ET AL: "Blocks-in-Conduit: REBCO Cable for a 20T@20K Toroid for Compact Fusion Tokamaks", IEEE TRANSACTIONS ON APPLIED SUPERCONDUCTIVITY, IEEE, USA, vol. 31, no. 5, 8 March 2021 (2021-03-08), pages 1 - 5, XP011849147, ISSN: 1051-8223, [retrieved on 20210412], DOI: 10.1109/TASC.2021.3064518
- TAKAYASU MAKOTO ET AL: "Electrical and Mechanical Characteristics of HTS Twisted Stacked-Tape Cable Conductor", IEEE TRANSACTIONS ON APPLIED SUPERCONDUCTIVITY, vol. 27, no. 4, 1 June 2017 (2017-06-01), USA, pages 1 - 5, XP093125285, ISSN: 1051-8223, Retrieved from the Internet <URL:https://ieeexplore.ieee.org/stampPDF/getPDF.jsp?tp=&arnumber=7823021&ref=aHR0cHM6Ly9pZWVleHBsb3JlLmllZWUub3JnL2RvY3VtZW50Lzc4MjMwMjE=> DOI: 10.1109/TASC.2017.2652307
- FIETZ W H ET AL: "High temperature superconductor cables for EU-DEMO TF-magnets", FUSION ENGINEERING AND DESIGN, ELSEVIER SCIENCE PUBLISHERS, AMSTERDAM, NL, vol. 125, 31 August 2017 (2017-08-31), pages 290 - 293, XP085305490, ISSN: 0920-3796, DOI: 10.1016/J.FUSENGDES.2017.07.025
- GRANETZ ROBERT: "Demonstration High Temperature Superconducting Non-Planar Stellarator Magnet with Advanced Manufactured Assemblies", 24 August 2020 (2020-08-24), pages 1 - 5, XP093125130, Retrieved from the Internet <URL:https://arpa-e.energy.gov/sites/default/files/2020-09/Day1_1630_TypeOne_Anderson.pdf> [retrieved on 20240130]

## Description

### BACKGROUND

### 1. Technical Field

The apparatus and techniques described herein relate to non-planar high temperature superconductor (HTS) cables which may perform magnetic confinement in a stellarator or find use in other applications, and to manufacturing techniques for forming non-planar HTS cables.

### 2. Discussion of the Related Art

Nuclear fusion for power generation may use magnetic confinement to confine a plasma within a reactor. Besides the tokamak, the stellarator is the only other credible magnetic confinement concept to date. Although energy confinement in stellarators is currently not as good as in tokamaks, the stellarator has a number of attractive features, including lack of disruptions, and steady-state operation. The most advanced stellarators utilize quasi-symmetries of the magnetic field to attempt to enhance particle confinement, but this can require extreme 3D non-planar coils of exacting geometry to produce the necessary field structure. Standard NbTi superconductor has been successfully used in the construction of these large 3D non-planar coils for the W7-X stellarator, which has a maximum B-field of 3 tesla on axis.

ZACHARY S HARTWIG ET AL: "VIPER: an industrially scalable high-current high-temperature superconductor cable", SUPERCONDUCTOR SCIENCE AND TECHNOLOGY, IOP PUBLISHING, TECHNO HOUSE, BRISTOL, GB, vol. 33, no. 11, 7 October 2020, discloses a vacuum pressure impregnated, insulated, partially transposed, extruded, and roll-formed (VIPER) cable. The VIPER cable critical currents are stable over thousands of mechanical cycles at extreme electromechanical force levels, multiple cryogenic thermal cycles, and dozens of quench-like transient events. Two independent, integrated fiber-optic quench detectors outperform standard quench detection approaches.

### SUMMARY

According to a first aspect, there is provided a high temperature superconductor, HTS, cable according to claim 1.

The twist pitch may be less than 100 mm and the bend radius may be less than or equal to 100 mm.

The HTS cable may have a non-planar shape.

The HTS cable may have a shape of a stellarator conductor.

Some aspects relate to a stellarator according to claim 5.

According to a second aspect, there is provided a method of forming a high temperature superconductor, HTS, cable according to claim 6.

The method may comprise placing a HTS tape stack in a first channel of the at least one channel after twisting the former to the second twist pitch.

The method may comprise: coupling an extension to an end of the former,; anchoring at least one HTS tape stack to the extension; and inserting a first HTS tape stack of the at least one HTS tape stack into the channel while the first HTS tape stack is anchored to the extension.

The anchoring may comprise attaching the at least one HTS tape stack to the extension under tension.

The method may comprise cutting an end of the at least one HTS tape stack that is anchored to the extension; and after the cutting, removing the extension.

The coupling of the extension may comprise inserting a rod into a central cooling channel of the former and into the extension.

The phrases "HTS material" or "HTS superconductor" and the like refer to superconducting materials having a critical temperature above 30° K at self-field. One example of a ceramic HTS is rare-earth barium copper oxide (REBCO). HTS superconductors may be formed in tapes or tape stacks that include several layers of various materials. The HTS material may be REBCO, particularly yttrium barium copper oxide (YBCO).

### BRIEF DESCRIPTION OF DRAWINGS

In the drawings, each identical or nearly identical component that is illustrated in various figures is represented by a like reference character. For purposes of clarity, not every component may be labeled in every drawing. The drawings are not necessarily drawn to scale, with emphasis instead being placed on illustrating various aspects of the techniques and devices described herein.
FIG. 1 shows an example of a cable, according to some embodiments.
FIG. 2 shows an example of at least one cable in at least one plate, according to some embodiments.
FIG. 3 shows a support case for at least one cable, according to some embodiments.
FIG. 4A shows an example of a twist pitch of a cable, according to some embodiments.
FIG. 4B shows an example of a bend radius of a cable, according to some embodiments.
FIG. 5A shows an example of a tear in a former, according to some embodiments.
FIG. 5B shows an example of non-uniform twisting of channels of a former, according to some embodiments.
FIG. 5C shows an example of a flowchart of a method that includes performing an annealing operation before more tightly twisting a former.
FIG. 6A shows an example of a tight bend radius of a cable, according to some embodiments.
FIGS. 6B-6C show a plot illustrating critical current, according to some embodiments.
FIGS. 7A-7B show a cross-section of formers, according to some embodiments.
FIG. 7C shows a side view of a former according to the embodiment of FIG. 7A side-by-side with a former according to the embodiment of FIG. 7B, according to some embodiments.
FIG. 7D shows a flowchart of a method of forming an HTS able that includes forming channel sidewalls having an angle treater than 90° prior to twisting the former.
FIG. 8A shows an example of at least one compression block strapped down with cable ties, according to some embodiments.
FIG. 8B shows an example of a flowchart of a method that includes securing an HTS tape stack in a groove with a compression structure.
FIG. 9A shows an example of tape stacks wound into a former, according to some embodiments.
FIG. 9B shows an example of a main cable and a core extension, according to some embodiments.
FIG. 9C shows an example of tape stacks and a former with at least one wire wrap, according to some embodiments.
FIG. 9D shows a perspective view of at least one temporary wire wrap around a former and a tape stack, according to some embodiments.
FIG. 9E shows an example of a cable without a core extension, according to some embodiments.
FIG. 9F shows an example of a cable partially covered with a jacketing tube, according to some embodiments.
FIG. 9G shows a flowchart of a method that includes coupling an extension to an end of a former, and anchoring the HTS tape stack to the extension.
FIGS. 10A-10B show an example of an end of a cable without a core extension, according to some embodiments.
FIG. 11 shows a plot illustrating differential voltage, according to some embodiments.

### DETAILED DESCRIPTION

The apparatus and techniques described herein relate to forming HTS cables having a tight bend radius and/or complex 3D geometry. Such techniques may be used to form a 3D highly non-planar stellarator coil using HTS material. The apparatus and techniques described herein have the potential to significantly enhance the fusion performance of the stellarator reactor concept by enabling the fabrication of 3D non-planar coils using high temperature superconductor (HTS) to increase the achievable magnetic field, which may provide greatly enhanced performance.

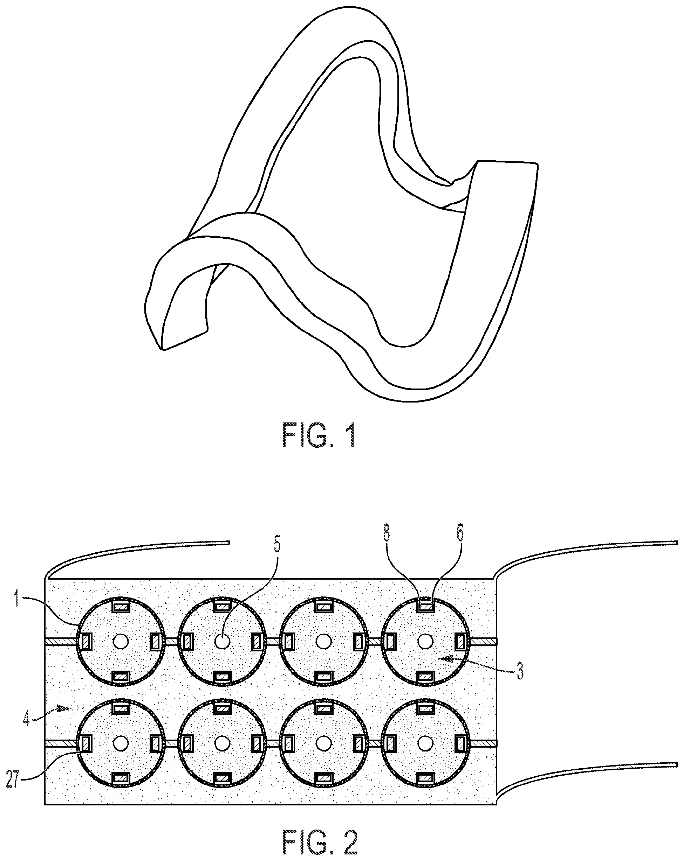

FIG. 1 shows a perspective view of a stellarator coil. One embodiment of the disclosed HTS cable has the same shape and size as one of the actual copper coils on the HSX stellarator device at University of Wisconsin, as shown in FIG. 1. However, the techniques and apparatus described herein are not limited to such a shape or to a particular sizes, as it should be appreciated that coils may be made in other suitable shapes and sizes. In addition to the highly non-planar geometry, the disclosed coil can have very tight bends, with bend radii as small as or smaller than 100 mm. Layer winding of the HTS tape stacks will not work in this geometry because the tape would be strained far beyond the approximately 0.4% strain limit at which it fails. To avoid high strain in the HTS conductor, the HTS tape stacks may be twisted along their length with a suitable twist pitch. The twisted stacked tape cable concept developed for the SPARC PF coils (VIPER), with appropriate modifications, may be used. The spiraling of the cable former and the fabrication method avoids bending the tape in the constrained direction, and may result in near zero strain on the tape post-bending, as long as the twist pitch is smaller than the bend radius, since the tapes redistribute along the pitch. Since the minimum bend radius of the proposed coil will be 100 mm, the twist pitch of the cable former may be reduced to ≤100 mm, which is about half that of the VIPER design.

As one example, two lengths of cable, each approximately 10 meters long, for example, may be bent into the precise 3D non-planar shapes for a stellarator using automated equipment to form two coils. The two lengths of cable may each have four turns of approximately 2 m circumference. At least 20 cm of HTS cable may be left at each cable end for joints and lead attachments. After confirming the geometrical accuracy (e.g., approximately 1 mm for the centroid of the conductors), the HTS tapes may be fixed in position. For example, a solder filling process, such as a vacuum pressure impregnation (VPI) process, may fill the voids in the tape stacks with a suitable solder alloy. Examples of a suitable VPI process are described in U.S. Published Patent Application 2022/0013256.

FIG. 2 shows an example of a HTS cable 1 disposed between a plurality of plates 4. The HTS cable 1 may include a former 3 having at least one channel 6 with one or more HTS tape stacks 8 disposed therein. Although four channels 6 are illustrated, each containing at least one HTS tape stack, this is an example, and the apparatus and techniques described herein are not limited to four channels with HTS tape stacks, and may have more or fewer channels, each of which may include one or more HTS tape stacks. The HTS cable 1 may include a central cooling channel 5. In some embodiments, the HTS cable 1 is a two-turn coil, and two 4-turn coils 1 may be clamped into at least one semi-circular groove 27 in two precisely fabricated 3D non-planar stainless steel "radial" plates 4 to form a coil including two pancakes of four turns each, as illustrated in FIG. 2. The two pancake plates may be connected (e.g., bolted) together along their inner and outer peripheries. The two pancake coils may be connected on the inboard side with a clamp-like low-resistance electrical joint (e.g., approximately 3 nΩ), as developed for SPARC, and a fluid cryogen joint.

Since superconducting stellarator coils operate in steady-state at near-zero voltage except during a quench, there is the option of either electrically insulating or not insulating the HTS cable from the radial support plates. For the insulated option, one option is to wrap the cable with an epoxy-impregnated layer, then clamp it into the radial plate grooves. A relatively low temperature heating cycle (much less than soldering temperature) may then be applied to the entire radial plate assembly to cure the insulator *in situ.* Another option is to wrap the cable with a thin layer of cryogenic-compatible compressible material such as silicone rubber. The insulating layer may also have the additional function of providing compliance for fitting the formed HTS cable coil into the radial support plates within the specified geometric tolerance.

For the non-insulated option, thin sheets of copper feltmetal may be used (as used in the sliding toroidal field magnet joints of the Alcator C-Mod tokamak), soldered into the semi-circular grooves in the radial plates to aid in current sharing between the HTS cable and the plates in the event of a quench. Soldering of the feltmetal into the semi-circular grooves may be done before the HTS cable is clamped in, thus avoiding an additional vacuum pressure impregnation (VPI) soldering process. The copper feltmetal may also provide compliance for fitting the HTS cable coil into the radial support plates within the specified geometric tolerance.

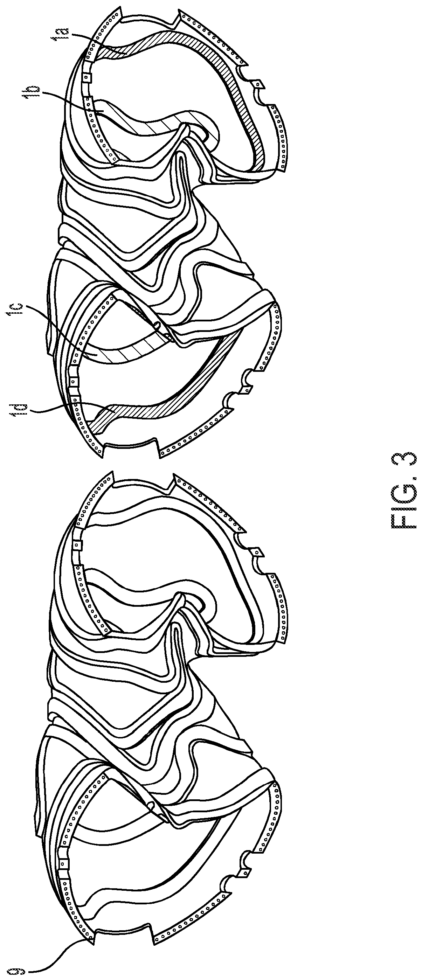

FIG. 3 shows a support case 9 for supporting at least one HTS cable 1a-1d in a stellarator configuration. In a full stellarator assembly, a support case 9 may be fabricated by precision 3D manufacturing (e.g., additive manufacturing) to precisely hold multiple non-planar coils (e.g., 1a-1d) in the required precise relative geometry, as illustrated in FIG. 3.

The completed stellarator coil may be cooled to 77 K by full immersion of the entire coil assembly into a pool of liquid nitrogen (LN2). The superconducting characteristics (critical current and exponent) can be measured and compared to theoretical calculations to verify the cable's integrity. Using Hall probes, a 3D mapping of the B-field around the coil may be compared to the desired field structure to confirm the geometrical precision of the coil fabrication.

The coil may also be purposely subjected to multiple quenches to confirm its survival, and to determine if there is any degradation in Ic. The quenches can be initiated by restricting the LN2 cooling, or by increasing the operating current. One or more small electric heaters may also be installed on the coil to initiate localized quenches. A quench will induce voltage across the coil leads due to both the resistivity of the copper former, and the finite inductance of the coil as the current is ramped down. Voltage taps at the leads and other critical locations, such as the pancake-to-pancake joint, may monitor the voltage.

The stellarator coil may also be tested at approximately 20 K using the test facility at the MIT Plasma Science and Fusion Center (PSFC). At this lower temperature the current carrying capacity of the HTS is much larger than at 77 K, and the self-induced electromagnetic forces on the coil (e.g., HTS cable 1) will be appreciable. Quench tests under these conditions will involve the release of much higher magnetic energy, and its conversion to thermal energy, so temperature measurements may be included in these tests. Coil performance may be compared to detailed engineering modeling.

The steps for fabricating straight sections of HTS VIPER cable up to 12 meters in length have already been developed and proven in the SPARC project. However, the adaptation of the VIPER cable design to accommodate requirements for the 3D non-planar stellarator coil resulted in a number of problems that led to changes in the cable design and in some of the fabrication methods.

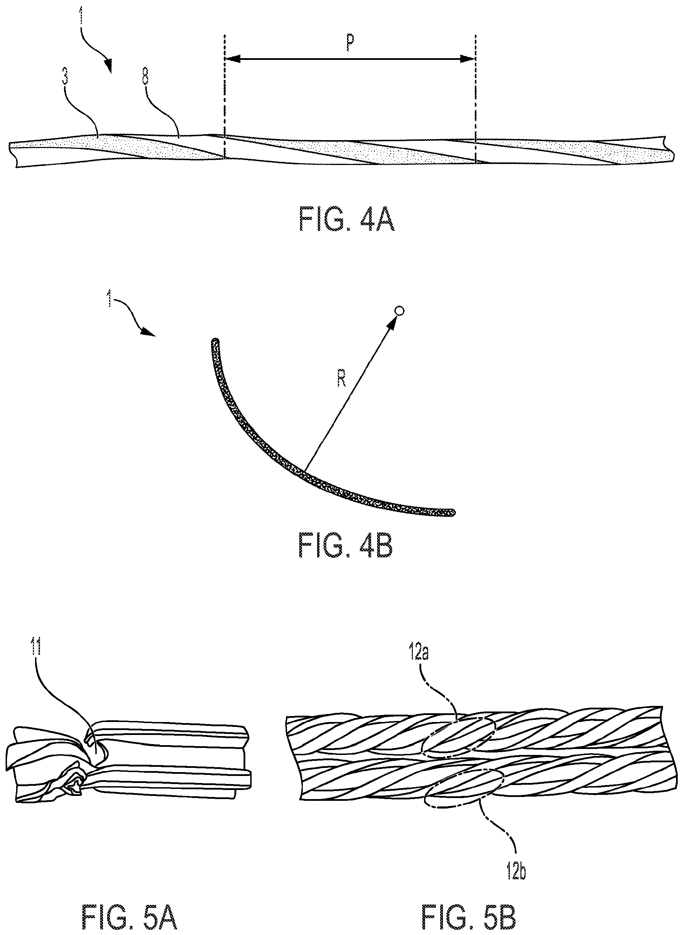

One difference for the HTS stellarator coil is that the twist pitch of the extruded copper core (former) may be reduced to accommodate the desired tight radius bends of the cable (e.g., to ≤100 mm). FIG. 4A illustrates the twist pitch P of a HTS cable 1 with a former 3 and tape stack 8 in a longitudinal direction. The twist pitch P is the distance along the length of the HTS cable 1 between portions of the HTS tape stack 8 at the same twist angle.

FIG. 4B illustrates the bend radius R of a HTS cable 1 at a particular position along the HTS cable 1. The bend radius R is the radius of a hypothetical circle having a same curvature of the HTS cable 1 at a particular position. In some embodiments, the twist pitch P is less than the bend radius R of the HTS cable 1.

This extra tight twisting resulted in several problems which led to a number of modifications and innovations to overcome these problems. One problem is that the extra torqueing deformed the copper extrusion in unacceptable ways. FIG. 5A shows an example of a tear 11 in a former. FIG. 5B shows an example of non-uniform twisting 12a, 12b in a former. Another problem that arose is the width of the channels in the extruded copper core (e.g., former) closed up enough to preclude insertion of 4 mm wide HTS tapes.

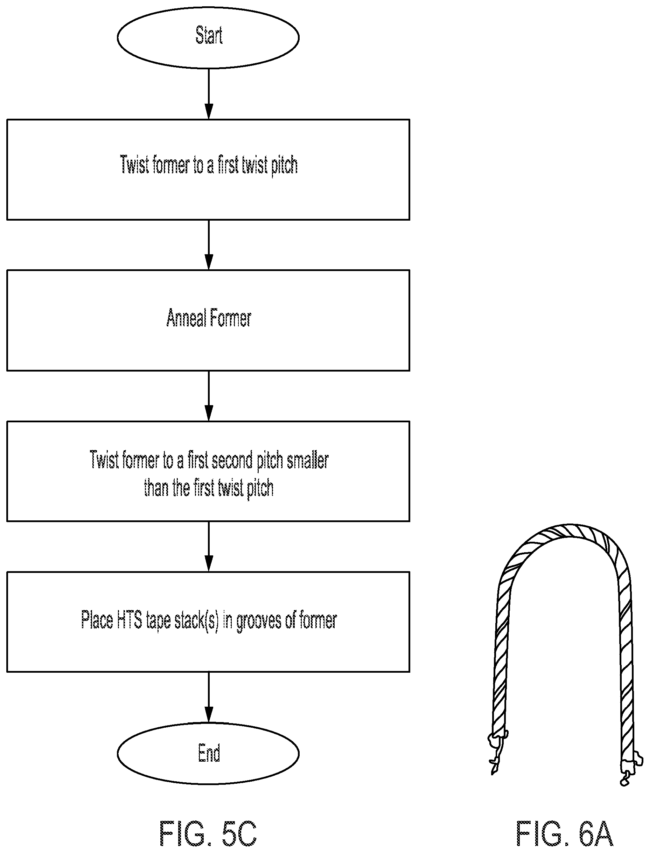

These problems may be reduced or eliminated by applying an intermediate annealing process in a vacuum oven, as illustrated in FIG. 5C. First, the former e.g., is twisted to a first twist pitch (e.g., 200 mm). Then an annealing process is performed. One example of suitable annealing parameters is four hours at a temperature of 600 C in vacuum. However, the techniques described herein are not limited to particular annealing temperatures, durations or environments. Following the annealing process, the former (e.g., 3) may be twisted to a second twist pitch (e.g., 100 mm) that is tighter than the first twist pitch. A pin may be used to restrict longitudinal shrinkage, which does not distort the copper appreciably. Following the twisting and annealing steps, the HTS tape stack(s) may be inserted into the channels of the former and secured in place.

In the first several tests of tightly bending (e.g., 97 mm bend radius) the tightly-twisted stellarator cable containing a stack of HTS tape (e.g., 8), the critical current at 77 K of tapes on the inner portion of the stack was reduced by up to 50% compared to virgin tape. FIG. 6A illustrates an example of a tight bend radius (e.g., the tight bend radius R shown in Fig. 4B) of an HTS cable.

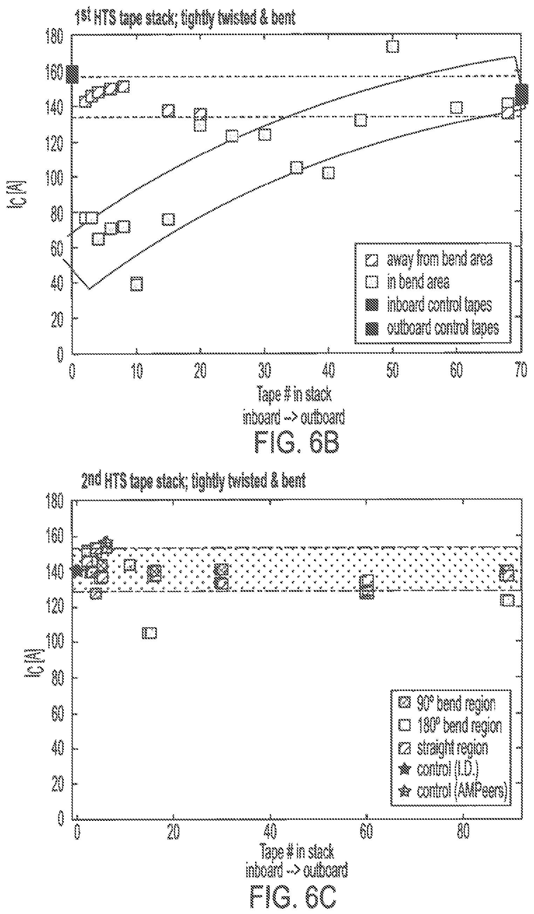

FIG. 6B shows a plot illustrating a reduction in critical current on the inboard side of the turn. FIG. 6C shows a plot illustrating the substantial degradation being entirely eliminated, by further expanding the channels of the extruded core by opening up the angle of the channel walls, or sidewalls, beyond 90° to ±15° beyond 90°.

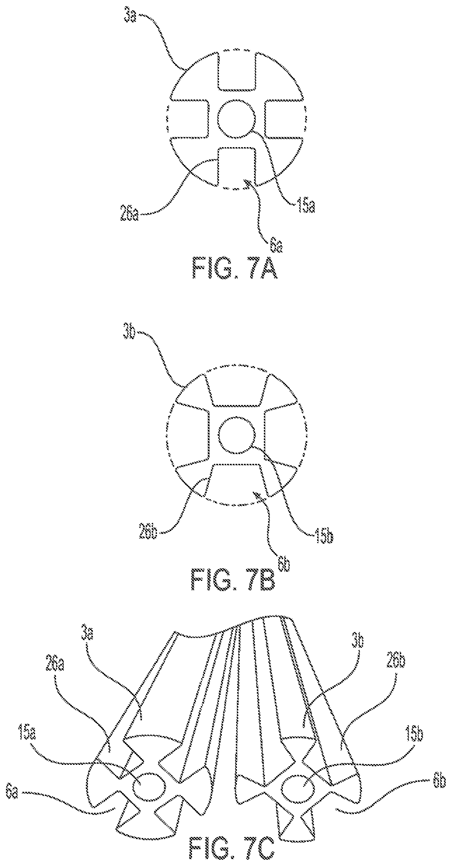

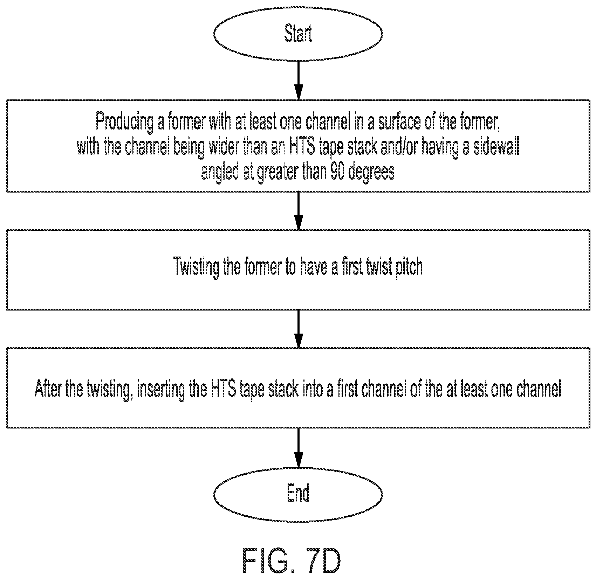

FIG. 7A illustrates a cross-section of a former 3a with at least one channel 6a with a sidewall 26a and a central cooling channel 15a. FIG. 7A shows at least one sidewall 26a of the at least one channel 6a at 90°. FIG. 7B shows a cross-section of a former 3b with at least one channel 6b with a sidewall 26b and a central cooling channel 15b. FIG. 7B shows at least one sidewall 26b of the at least one channel 14b at ±15° beyond 90°. The width of the at least one channel 6b in the former 3b, or the extruded copper core, was also widened from 5.0 mm to 6.0 mm. FIG. 7C shows the formers 3a, 3b, or the copper cores, illustrated in FIG. 7A (left) and FIG. 7B (right) positioned side-by-side. FIG. 7D shows a flowchart of a method of forming an HTS cable that includes forming channel sidewalls having an angle treater than 90° prior to twisting the former.

Manually winding multiple full stacks of tape, particularly stainless steel "dummy" tape, into the tightly-twisted extruded core (e.g., former) initially proved to be labor intensive and technically difficult, and the stacks of tape (e.g., 8) tended to bulge out beyond the height of the channels (e.g., 6a, 6b), resulting in irrecoverable failures when trying to insert the wound core into a close fitting jacketing tube. The basic problem is that a tightly twisted stack of HTS or steel tape acts like a strong spring, which will bulge out unless forced to stay in the channel. Initially this was done by application of strong tension along the tape stack, but this proved problematic for longer cables. Any unintentional release of tension during the winding process, even momentarily, would result in a protruding stack, which would then have to be completely removed and discarded. Two techniques substantially eased the winding procedure, thus decreasing the process time and ensuring a high success rate.

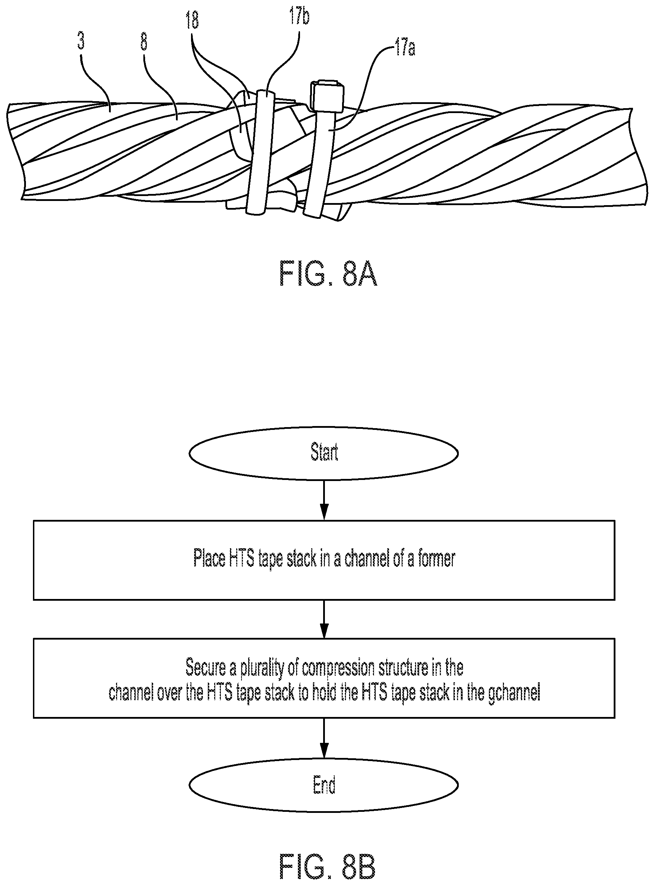

The first technique was to temporarily insert custom-made small compression blocks on top of each stack of tape as it was being wound into the channel, at a spacing of about every 50 cm along the cable length, and strapped down with cable ties, as illustrated in FIG. 8A. FIG. 8A shows an example of compression blocks 18 strapped down in a channel of the former 3 with cable ties 17a, 17b, which are around the compression blocks 18, tape stack 8, and a former 3. However, any suitable spacing may be used, and the compression blocks 18, or other compression structure, may be held or strapped down with any suitable device or structure, not limited to cable ties 17a, 17b, or straps. The compression blocks 18 are narrow enough to fit in the channels of the former and thick enough to press down firmly on the HTS tape stacks 8. The particular dimensions of the compression blocks 18 selected for use with the copper core (e.g., former) described herein are 6.0 mm width x 12.5 mm length x 3.2 mm thickness. However, the size of the compression blocks 18 is not limited to such dimensions. The choice of material for the compression blocks 18 is not critical. Preferably, the compression blocks 18 include a rigid material. In some embodiments, the material of the compression blocks 18 may be G10 (glass epoxy impregnation). However, the compression blocks 18 described herein are not limited to particular materials. In some embodiments, edges of the compression blocks 18 may be chamfered to avoid damaging the HTS tape stacks 8. The compression blocks 18 effectively prevent bulging of the tape stacks 8, even when tension on the stack 8 is released. FIG. 8B shows an example of a flowchart illustrating such a technique.

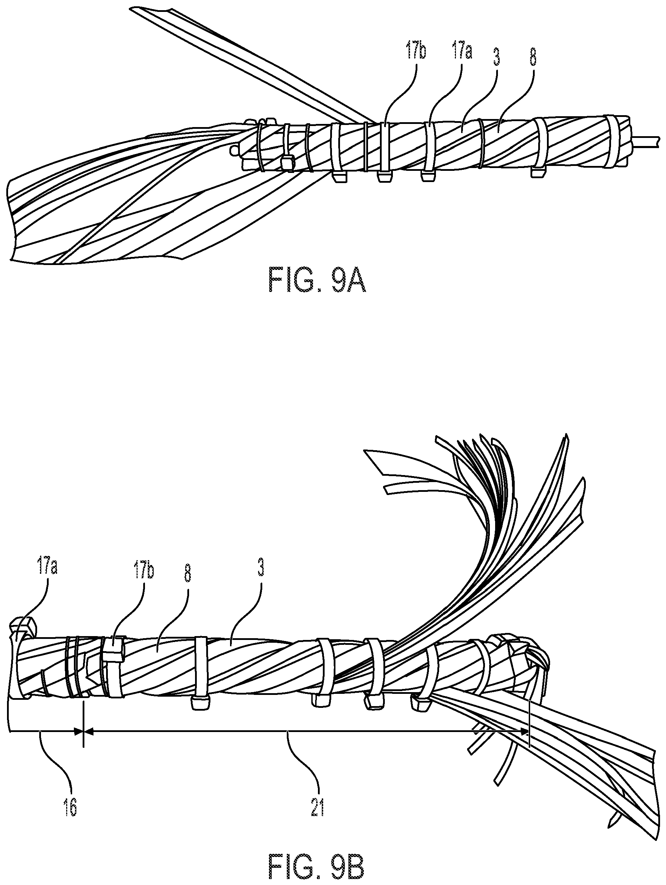

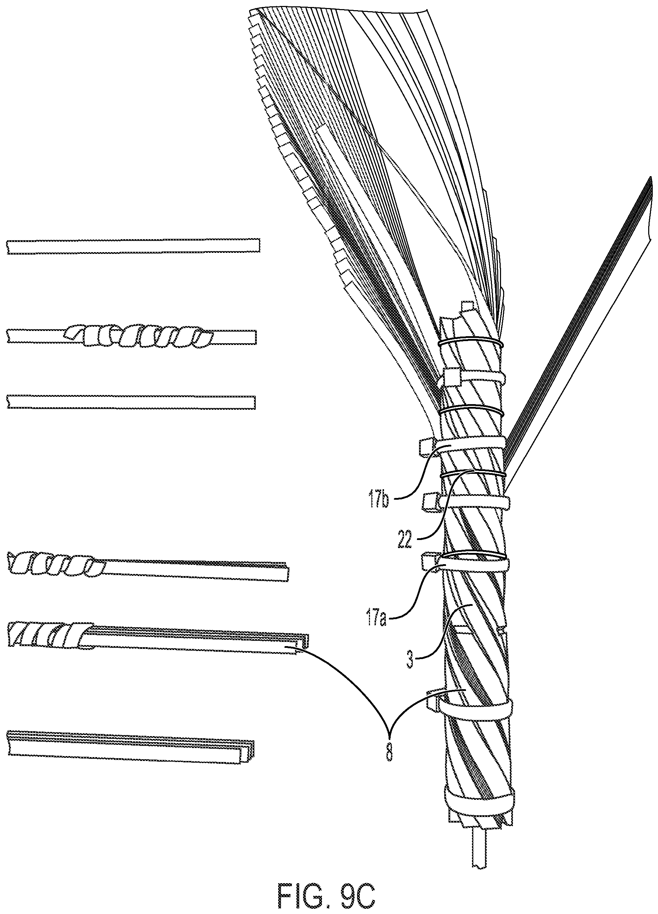

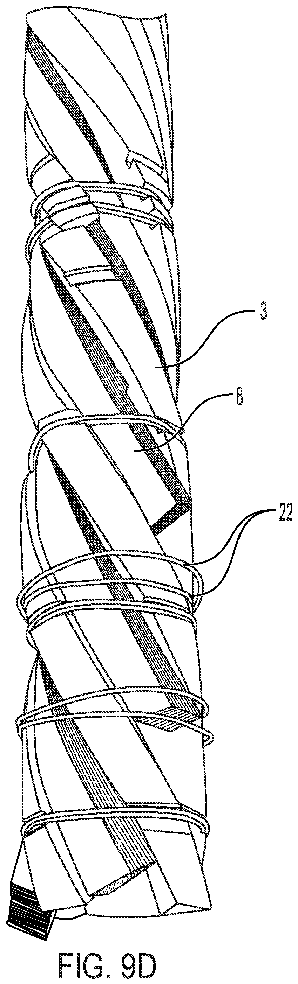

The cable ties and compression blocks may eventually be removed when the wound core is inserted into a close-fitting jacketing tube, so it can be helpful to firmly anchor the ends of the tape stacks with tension applied. Due to mechanical interferences between stacks when winding multiple stacks into a core, it may not be feasible to do this anchoring directly at the ends of the desired core. To enable secure anchoring with multiple stacks, short core extensions are fitted onto the ends of the desired core by sliding them onto temporary copper rods inserted into the central coolant channel (e.g., 15a, 15b), as illustrated in FIGS. 9A-9D. FIG. 9A shows an example of tape stacks 8 wound into a former 3. FIG. 9B illustrates a main cable 16 and a core extension 21. The core extensions 21 may be short lengths of the same twisted copper extrusions used to form the copper core (e.g., former 3), as illustrated in FIG. 9B. These core extensions 21 are temporary, removable, and fully reusable. The tape stacks are secured in the extensions using the aforementioned compression blocks 18 and cable ties 17a, 17b, and the core extensions 21 are long enough (e.g., approximately 140 mm or longer, such as 150 mm) to accommodate multiple tape stacks 8 without mechanical interference between stacks 8. This allows strong tension to be kept on all the tape stacks 8. The permanent anchoring at the ends of the desired core may be done by a wire-wrap process in shallow grooves machined near the ends of the core. FIG. 9C illustrates a former 3 and a tape stack 8 with at least one wire wrap 22. A temporary wire wrap process is done on the mating ends of the temporary extensions, as illustrated in FIG. 9C. FIG. 9D illustrates a perspective view of temporary wire wrap 22 around a former 3 and a tape stack 8. This wire wrap process was developed previously for the VIPER cable, but use of the temporary core extensions (e.g., 21) improves the quality of this process.

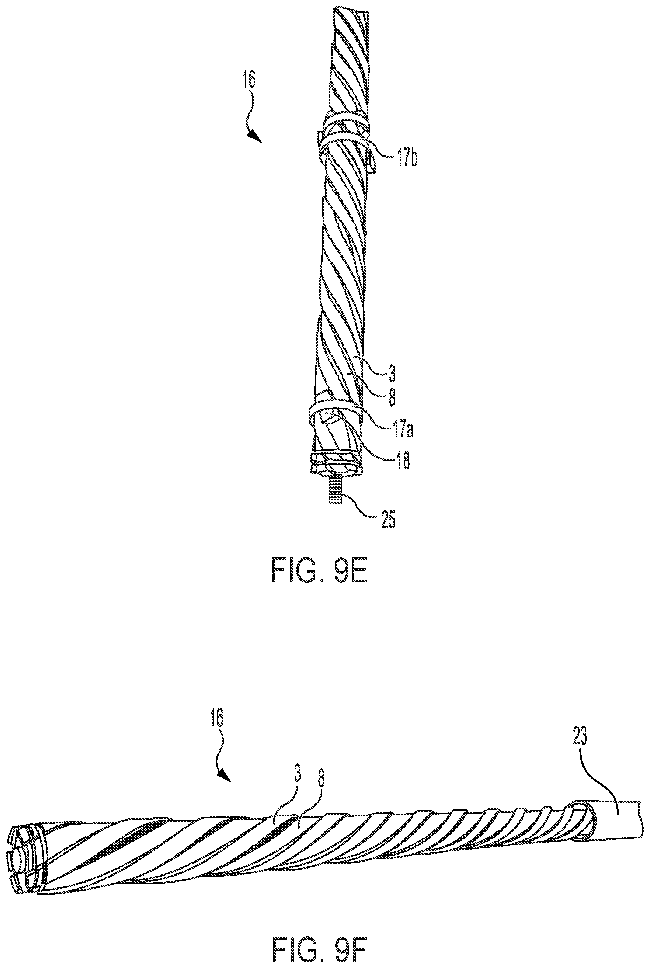

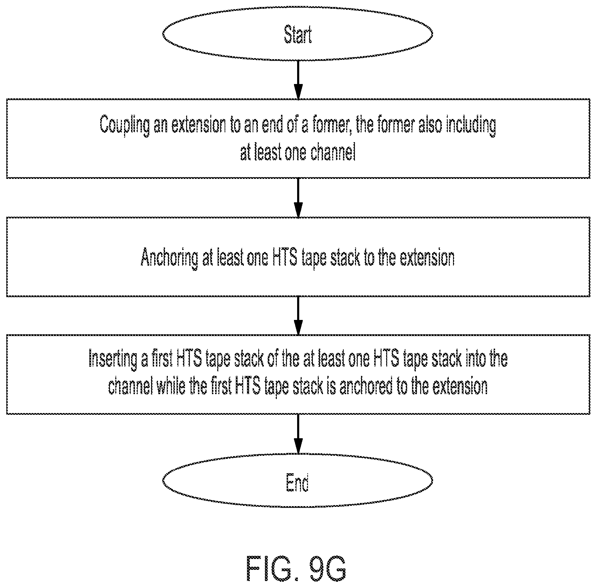

After wire wrapping, an abrasive cutting wheel may be used to cut through the tape stacks (e.g., 8) between the ends of the core (e.g., former 3) and the mating ends of the extensions (e.g., 21), thus freeing the extensions (e.g., 21) for removal and reuse. FIG. 9E illustrates a main cable 16 without an extension (e.g., 21). FIG. 9E shows a protruding rod 25 onto which extensions (e.g., 21) are slid onto when in use. FIG. 9F illustrates a main cable 16 without an extension (e.g., 21) with cable jacket 23 (e.g. a copper tube) partially covering a tape stack 8 and a former 3. FIG. 9G shows a flowchart of a method that includes coupling an extension to an end of a former, and anchoring the HTS tape stack to the extension.

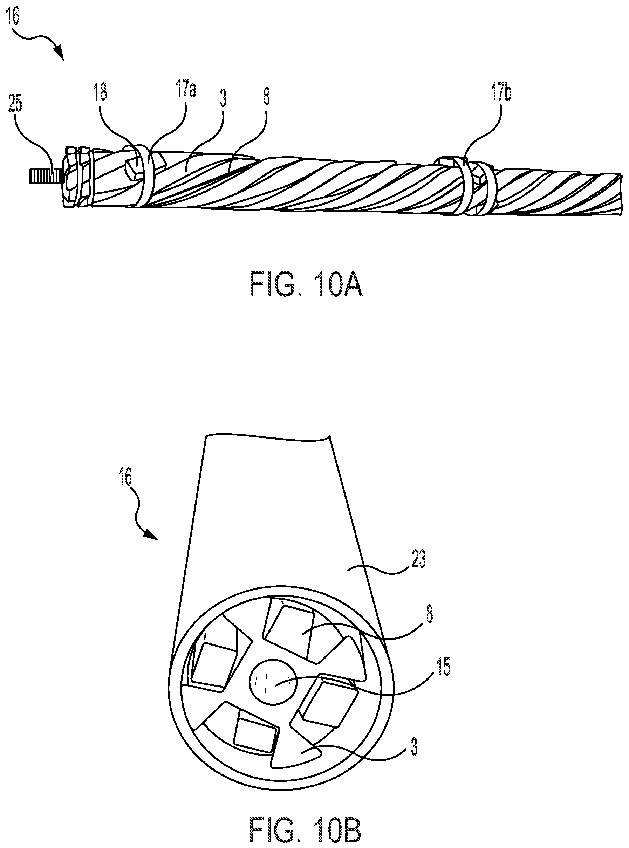

The use of an abrasive cutting wheel to remove the extension leaves the cable with much cleaner ends than with the original VIPER process, as shown in FIGS. 10A and 10B. FIG. 10A shows an example of an end of a main cable 16 after use of an abrasive cutting wheel (not shown) with a rod 25 protruding therefrom. FIG. 10B shows a perspective view of a main cable 16 after use of an abrasive cutting wheel (not shown) with a central cooling channel 15. The combination of the compression blocks 18 and the temporary extensions 21 is a significant improvement to the process for manual winding of multiple tape stacks 8, allowing the procedure to be efficiently done with only two people, and allowing successful insertion of the wound core (e.g., former 19) into the close-fitting copper jacketing tube 23, thus eliminating wasteful losses of rejected tape stacks 8. However, in some embodiments, the compression blocks 18 or temporary extensions 21 may be used on their own, and not in combination, as it is not required that such techniques be used in combination in all cases.

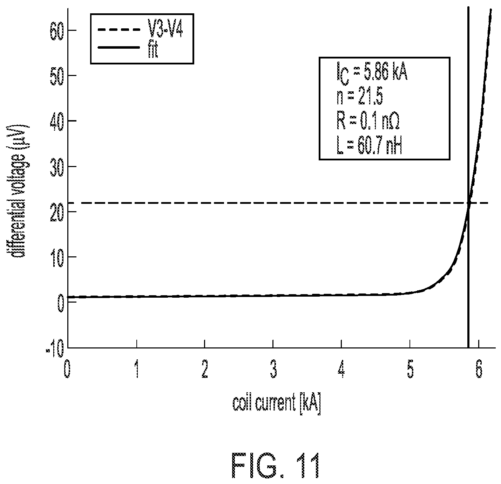

After the wound core (e.g., former 3) has been inserted into the cable jacket 23, the ensuing roll forming and VPI soldering processes may be unchanged from those previously developed for the VIPER cable. Procedures for testing in liquid nitrogen to determine the critical current characteristics (Ic and 'n' exponent) at 77 K are also unchanged. Excellent results have been achieved on several stellarator cable samples, with measured Ic = 5.8 kA and n≈21, as illustrated in FIG. 11, which closely matches the theoretical calculations.

Although the techniques and structures described herein may be used for stellarator coils, the present disclosure is not so limited, as the techniques and structures described herein may be used for any superconducting cables, and in particular superconducting cables with HTS tape stacks regardless of bend radius R.

Examples of VIPER cables are described in U.S. patent 8,437,819, in which the twisted stacked tape cable (TSTC) was introduced, including a version with multiple grooves on the former. U.S. patent 8,437,819.

Using HTS for the 3D non-planar coils will allow operation at significantly higher magnetic field, leading to higher fusion power and/or more compact size for stellarator fusion reactors.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

The use of "including," "comprising," or "having," "containing," "involving," and variations thereof herein, is meant to encompass the items listed thereafter and equivalents thereof as well as additional items.

The terms "approximately", and "about" may be used to mean within ±20% of a target value in some embodiments, within ± 10% of a target value in some embodiments, within ±5% of a target value in some embodiments, and within ±2% of a target value in some embodiments. The terms "approximately," "substantially," and "about" may include the target value.

## Claims

1. A high temperature superconductor, HTS, cable (1), comprising:
a former (3) having at least one channel (6);
at least one HTS tape stack (8), wherein a first HTS tape stack of the at least one HTS tape stack is disposed in a first channel of the at least one channel, and
wherein the first HTS tape stack and the first channel are twisted along a longitudinal direction of the HTS cable, wherein the first HTS tape stack has a twist pitch at a first location of the HTS cable that is smaller than a bend radius of the HTS cable at the first location.

2. The HTS cable of claim 1, wherein the twist pitch is less than 100 mm and the bend radius is less than or equal to 100 mm.

3. The HTS cable of claim 1 or claim 2, wherein the HTS cable has a non-planar shape.

4. The HTS cable of claim 3, wherein the HTS cable has a shape of a stellarator conductor.

5. A stellarator, comprising the HTS cable of claim 1.

6. A method of forming a high temperature superconductor, HTS, cable (1), the method comprising:
twisting a former (3) to a first twist pitch, the former having at least one channel (6);
after twisting the former to the first twist pitch, annealing the former; and
after annealing the former, twisting the former to a second twist pitch smaller than the first twist pitch.

7. The method of claim 6, further comprising placing a HTS tape stack (8) in a first channel of the at least one channel after twisting the former to the second twist pitch.

8. The method of claim 6, the method further comprising:
coupling an extension (21) to an end of the former;
anchoring at least one HTS tape stack to the extension; and
inserting a first HTS tape stack of the at least one HTS tape stack into the channel while the first HTS tape stack is anchored to the extension.

9. The method of claim 8, wherein the anchoring comprises attaching the at least one HTS tape stack to the extension under tension.

10. The method of claim 8 or claim 9, further comprising:
cutting an end of the at least one HTS tape stack that is anchored to the extension; and
after the cutting, removing the extension.

11. The method of any of claims 8-10, wherein the coupling of the extension comprises inserting a rod into a central cooling channel of the former and into the extension.

12. The method of claim 8, the method further comprising:
securing a plurality of compression structures (18) in the channel over the first HTS tape stack at a plurality of respective locations along the channel to hold the first HTS tape stack in the channel.

13. The method of claim 12, further comprising removing the plurality of compression structures from the channel.

14. The method of claim 12 or claim 13, further comprising fitting a cable jacket over the former and the first HTS tape stack.

15. The method of any of claims 12-14, wherein the plurality of compression structures are secured with ties or straps.

## Patentansprüche

1. Ein Hochtemperatursupraleiterkabel, HTS-Kabel, (1), das Folgendes beinhaltet:
einen Former (3), der mindestens einen Kanal (6) aufweist;
mindestens einen HTS-Bandstapel (8), wobei ein erster HTS-Bandstapel des mindestens einen HTS-Bandstapels in einem ersten Kanal des mindestens einen Kanals angeordnet ist und
wobei der erste HTS-Bandstapel und der erste Kanal entlang einer Längsrichtung des HTS-Kabels verdrillt sind, wobei der erste HTS-Bandstapel eine Verdrillsteigung an einer ersten Stelle des HTS-Kabels aufweist, die kleiner als ein Biegeradius des HTS-Kabels an der ersten Stelle ist.

2. HTS-Kabel gemäß Anspruch 1, wobei die Verdrillsteigung kleiner als 100 mm ist und der Biegeradius kleiner als oder gleich 100 mm ist.

3. HTS-Kabel gemäß Anspruch 1 oder Anspruch 2, wobei das HTS-Kabel eine nichtplanare Form aufweist.

4. HTS-Kabel gemäß Anspruch 3, wobei das HTS-Kabel eine Form eines Stellaratorleiters aufweist.

5. Ein Stellarator, der das HTS-Kabel gemäß Anspruch 1 beinhaltet.

6. Ein Verfahren zum Bilden eines Hochtemperatursupraleiterkabels, HTS-Kabels, (1), wobei das Verfahren Folgendes beinhaltet:
Verdrillen eines Formers (3) auf eine erste Verdrillsteigung, wobei der Former mindestens einen Kanal (6) aufweist;
nach dem Verdrillen des Formers auf die erste Verdrillsteigung, Glühen des Formers;
und
nach dem Glühen des Formers, Verdrillen des Formers auf eine zweite Verdrillsteigung, die kleiner als die erste Verdrillsteigung ist.

7. Verfahren gemäß Anspruch 6, das nach dem Verdrillen des Formers auf die zweite Verdrillsteigung ferner das Platzieren eines HTS-Bandstapels (8) in einem ersten Kanal des mindestens einen Kanals beinhaltet.

8. Verfahren gemäß Anspruch 6, wobei das Verfahren ferner Folgendes beinhaltet:
Koppeln einer Verlängerung (21) an ein Ende des Formers;
Verankern mindestens eines HTS-Bandstapels an der Verlängerung; und
Einführen eines ersten HTS-Bandstapels des mindestens einen HTS-Bandstapels in den Kanal, während der erste HTS-Bandstapel an der Verlängerung verankert ist.

9. Verfahren gemäß Anspruch 8, wobei das Verankern das Befestigen des mindestens einen HTS-Bandstapels an der Verlängerung unter Spannung beinhaltet.

10. Verfahren gemäß Anspruch 8 oder Anspruch 9, das ferner Folgendes beinhaltet:
Abschneiden eines Endes des mindestens eines HTS-Bandstapels, der an der Verlängerung verankert ist; und
nach dem Abschneiden, Entfernen der Verlängerung.

11. Verfahren gemäß einem der Ansprüche 8-10, wobei das Koppeln der Verlängerung das Einführen eines Stabs in einen zentralen Kühlmittelkanal des Formers und in die Verlängerung beinhaltet.

12. Verfahren gemäß Anspruch 8, wobei das Verfahren ferner Folgendes beinhaltet:
Sichern einer Vielzahl von Kompressionsstrukturen (18) in dem Kanal über dem ersten HTS-Bandstapel an einer Vielzahl von jeweiligen Stellen entlang des Kanals, um den ersten HTS-Bandstapel in dem Kanal zu halten.

13. Verfahren gemäß Anspruch 12, das ferner das Entfernen der Vielzahl von Kompressionsstrukturen aus dem Kanal beinhaltet.

14. Verfahren gemäß Anspruch 12 oder Anspruch 13, das ferner das Anbringen eines Kabelmantels über dem Former und dem ersten HTS-Bandstapel beinhaltet.

15. Verfahren gemäß einem der Ansprüche 12-14, wobei die Vielzahl von Kompressionsstrukturen mit Bindern oder Riemen gesichert werden.

## Revendications

1. Un câble supraconducteur à haute température, HTS, (1), comprenant :
un gabarit (3) présentant au moins une cannelure (6) ;
au moins un empilement de rubans HTS (8), un premier empilement de rubans HTS parmi l'au moins un empilement de rubans HTS étant disposé dans une première cannelure parmi l'au moins une cannelure ; et
dans lequel le premier empilement de rubans HTS et la première cannelure sont torsadés le long d'une direction longitudinale du câble HTS, le premier empilement de rubans HTS présentant un pas de torsadage à un premier emplacement du câble HTS qui est plus petit qu'un rayon de courbure du câble HTS au premier emplacement.

2. Le câble HTS de la revendication 1, dans lequel le pas de torsadage est inférieur à 100 mm et le rayon de courbure est inférieur ou égal à 100 mm.

3. Le câble HTS de la revendication 1 ou de la revendication 2, le câble HTS présentant une forme non plane.

4. Le câble HTS de la revendication 3, le câble HTS présentant la forme d'un conducteur de stellarateur.

5. Un stellarateur, comprenant le câble HTS de la revendication 1.

6. Un procédé de formation d'un câble supraconducteur à haute température, HTS, (1), le procédé comprenant :
le torsadage d'un gabarit (3) à un premier pas de torsadage, le gabarit présentant au moins une cannelure (6) ;
après le torsadage du gabarit au premier pas de torsadage, le recuit du gabarit ; et
après le recuit du gabarit, le torsadage du gabarit à un deuxième pas de torsadage plus petit que le premier pas de torsadage.

7. Le procédé de la revendication 6, comprenant en outre le placement d'un empilement de rubans HTS (8) dans une première cannelure parmi l'au moins une cannelure après le torsadage du gabarit au deuxième pas de torsadage.

8. Le procédé de la revendication 6, le procédé comprenant en outre :
le couplage d'une extension (21) à une extrémité du gabarit ;
l'ancrage d'au moins un empilement de rubans HTS à l'extension ; et
l'insertion d'un premier empilement de rubans HTS parmi l'au moins un empilement de rubans HTS dans la cannelure pendant que le premier empilement de rubans HTS est ancré à l'extension.

9. Le procédé de la revendication 8, dans lequel l'ancrage comprend la solidarisation de l'au moins un empilement de rubans HTS à l'extension sous tension mécanique.

10. Le procédé de la revendication 8 ou de la revendication 9, comprenant en outre :
la coupe d'une extrémité de l'au moins un empilement de rubans HTS qui est ancré à l'extension ; et
après la coupe, le retrait de l'extension.

11. Le procédé de n'importe lesquelles des revendications 8 à 10, dans lequel le couplage de l'extension comprend l'insertion d'une tige dans un canal de refroidissement central du gabarit et dans l'extension.

12. Le procédé de la revendication 8, le procédé comprenant en outre :
l'assujettissement d'une pluralité de structures de compression (18) dans la cannelure au-dessus du premier empilement de rubans HTS à une pluralité d'emplacements respectifs le long de la cannelure pour maintenir le premier empilement de rubans HTS dans la cannelure.

13. Le procédé de la revendication 12, comprenant en outre le retrait de la pluralité de structures de compression hors de la cannelure.

14. Le procédé de la revendication 12 ou de la revendication 13, comprenant en outre l'installation d'une gaine de câble au-dessus du gabarit et du premier empilement de rubans HTS.

15. Le procédé de n'importe lesquelles des revendications 12 à 14, dans lequel la pluralité de structures de compression sont assujetties par des liens ou des sangles.
